# FASCICULE DE BREVET EUROPEEN

(11) **EP 4 431 753 B1**
(45) Date de publication et mention de la délivrance du brevet: **18.02.2026**
(21) Numéro de dépôt: 24162856.9
(22) Date de dépôt: 12.03.2024
(51) Int. Cl.: F16B 37/14

(54) **DISPOSITIF DE FIXATION PAR VISSAGE MUNI D'UN CACHE VIS**
SCHRAUBBEFESTIGUNGSVORRICHTUNG MIT SCHRAUBABDECKUNG
SCREW FASTENING DEVICE WITH A SCREW CAP

(30) Priorité: 17.03.2023 FR 2302495
(43) Date de publication de la demande: 18.09.2024
(73) Titulaire: SEB S.A., 69130 Ecully (FR)
(72) Inventeur: GIRAUD, Jean-Baptiste, 69134 Ecully Cedex (FR); GUILLOT, Annabelle, 69134 Ecully Cedex (FR); VETILLARD, Alban, 69134 Ecully Cedex (FR)
(74) Mandataire: SEB Développement

(56) Documents cités:
- JP-A- 2004 225 738
- JP-A- 2005 331 023
- KR-B1- 101 936 128
- US-A- 5 501 559

## Description

### Domaine technique

La présente invention se rapporte au domaine technique général des dispositifs pour fixer ensemble des pièces d'appareil, plus particulièrement des dispositifs de fixation par vissage d'un panneau sur un bâti d'un appareil domestique qui comportent un cache vis.

### Etat de la technique

Il est connu du document KR200467396 un dispositif de fixation par vissage d'un panneau sur un bâti d'un appareil domestique, notamment un appareil de conditionnement d'air. Le dispositif de fixation par vissage comporte une vis munie d'une tête ainsi qu'un cache vis. Le panneau comporte un trou de passage de la vis et un trou de réception de la tête de la vis. Le cache vis est mobile entre une position fermée dans laquelle le cache vis est positionné dans un logement agencé dans le prolongement du trou de réception de la tête de vis pour fermer le trou de réception de la tête de la vis et une position ouverte dans laquelle le cache vis est séparé du panneau pour libérer l'accès au trou de réception de la tête de vis. Le logement comporte une rainure latérale qui permet l'introduction d'un outil pour prendre appui sur un coté du cache vis et faire sortir le cache vis du logement pour le faire passer dans la position ouverte.

Cependant, un tel dispositif nécessite un outil spécifique pour ôter le cache vis de son logement. De plus, l'outil peut abimer le coté du cache vis lors de l'opération de retrait du cache vis.

La rainure forme également un orifice qui peut se salir et être difficile à nettoyer. De plus une telle rainure est peu esthétique. Un autre dispositif de fixation par vissage est connu de JP 2005 331023 A.

### Résumé de l'invention

La présente invention vise à remédier à ces inconvénients.

Le problème technique à la base de l'invention consiste à proposer un dispositif de fixation par vissage comportant un cache vis qui est facilement démontable, sans outil spécifique.

Un autre but de l'invention est de proposer un dispositif de fixation qui présente une conception simple, esthétique et économique à mettre en œuvre.

A cet effet, l'invention a pour objet un appareil domestique tel que défini à la revendication 1.

Par panneau, on comprend un panneau constituant une partie visible de l'enveloppe extérieure de l'appareil domestique.

Ainsi, l'utilisateur peut utiliser un objet du quotidien pour appuyer sur la zone périphérique du cache vis pour le faire basculer dans la position inclinée de saisie. En conséquence, l'utilisateur n'a pas à mettre en œuvre un outil spécifique pour ôter le cache vis.

Avantageusement, le trou de réception de la tête de la vis comporte une extrémité libre et l'extrémité libre comporte une collerette qui est entourée par la rainure périphérique.

Ainsi, la collerette forme une portion d'appui au cache vis pour lui permettre de basculer dans la position inclinée de saisie.

De préférence, le logement de réception comporte une paroi externe périphérique et le bord périphérique du cache vis comporte une face externe périphérique, la face externe périphérique étant positionnée à proximité de la paroi externe périphérique lorsque le cache vis est dans la position fermée.

Ainsi, le cache vis est ajusté au logement pour obtenir un assemblage esthétique et peu sensible aux salissures.

Avantageusement, le logement de réception et le cache vis sont circulaires.

De préférence, le cache vis présente un diamètre extérieur D1 et le bord périphérique s'étend au-dessus de la rainure périphérique sur une distance d, la distance d étant supérieure ou égale à D1/10.

Ainsi, le bord périphérique qui s'étend au-dessus de la rainure périphérique forme un bras de levier suffisant pour faire passer le cache vis de la position fermée dans la position inclinée de saisie.

Avantageusement, le cache vis comporte un organe de maintien agencé dans le trou de réception de la tête de la vis lorsque le cache vis est dans la position fermée.

Ainsi, l'organe de maintien est agencé dans une zone qui n'interfère pas avec le bord périphérique.

De préférence, l'organe de maintien est formé par des pattes qui sont agencées de manière serrante dans une extrémité libre du trou de réception de la tête de la vis lorsque le cache vis est dans la position fermée.

Avantageusement, dans la position fermée, les pattes s'étendent le long d'un axe longitudinal d'extension de la vis sur une longueur L et le trou de réception de la tête de vis présente un diamètre D2, la longueur L étant inférieure à D2/4.

Une telle disposition permet aux pattes opposées à l'appui d'échapper du trou de réception de la tête de vis dans une faible portion de la rotation du cache vis pour passer de la position fermée dans la position inclinée de saisie
De préférence, chaque patte comporte un bourrelet d'extrémité.

Une telle disposition permet de limiter le frottement au niveau du bourrelet de la patte lorsque le cache vis passe de la position fermée dans la position inclinée de saisie.

### Brève description des figures

On comprendra mieux les buts, aspects et avantages de la présente invention, d'après la description donnée ci-après d'un mode particulier de réalisation de l'invention présenté à titre d'exemple non limitatif, en se référant aux dessins annexés dans lesquels :
[Fig 1] La figure 1 est une vue en perspective d'un appareil domestique comportant un dispositif de fixation selon un mode particulier de réalisation de l'invention.
[Fig 2] La figure 2 est une vue de détail II de la figure 1, le cache vis étant en position ouverte.
[Fig 3] La figure 3 est une vue en coupe partielle suivant le plan de coupe vertical suivant la ligne III-III du dispositif de fixation de la figure 1, le cache vis étant dans la position fermée.
[Fig 4] La figure 4 est une vue en coupe partielle suivant le plan de coupe vertical suivant la ligne III-III du dispositif de fixation de la figure 1, le cache vis étant dans la position inclinée de saisie.

Seuls les éléments nécessaires à la compréhension de l'invention ont été représentés. Pour faciliter la lecture des dessins, les mêmes éléments portent les mêmes références d'une figure à l'autre.

On notera que dans ce document, les termes "horizontal", "vertical", "inférieur", "supérieur", "haut", "bas", "avant", "arrière", "longitudinal", "transversal", employés pour décrire le dispositif de fixation font référence à cette machine reposant sur un plan de travail, en situation d'usage.

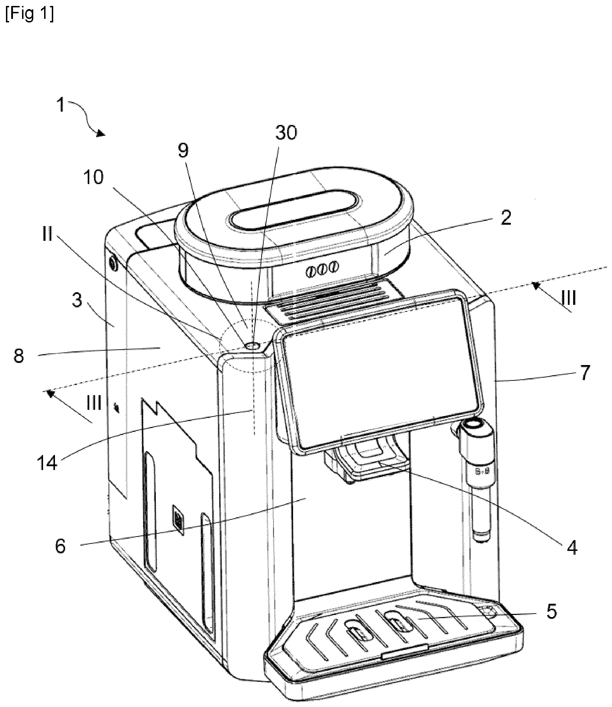

Dans l'exemple de réalisation représenté aux figures 1 à 4, un appareil domestique 1, plus particulièrement une machine à café comporte un bac à grains de café 2, un réservoir 3 formant une alimentation en eau froide et une tête de distribution 4 du café. La tête de distribution 4 est agencée au-dessus d'un repose-tasse 5 et elle est montée mobile en translation verticale pour permettre à un utilisateur d'ajuster la position d'une sortie de café à la hauteur de la tasse posée sur le repose-tasse 5. La machine à café comporte un bâti 6, un panneau 7 d'habillage droit, un panneau 8 d'habillage gauche et un panneau 9 d'habillage supérieur formant un capot.

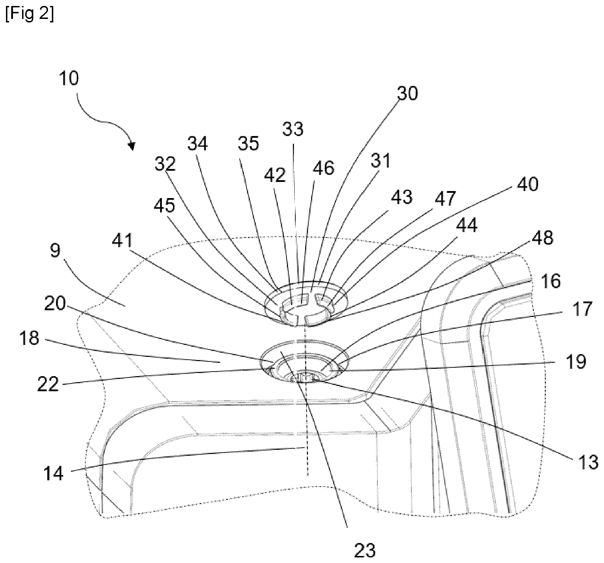

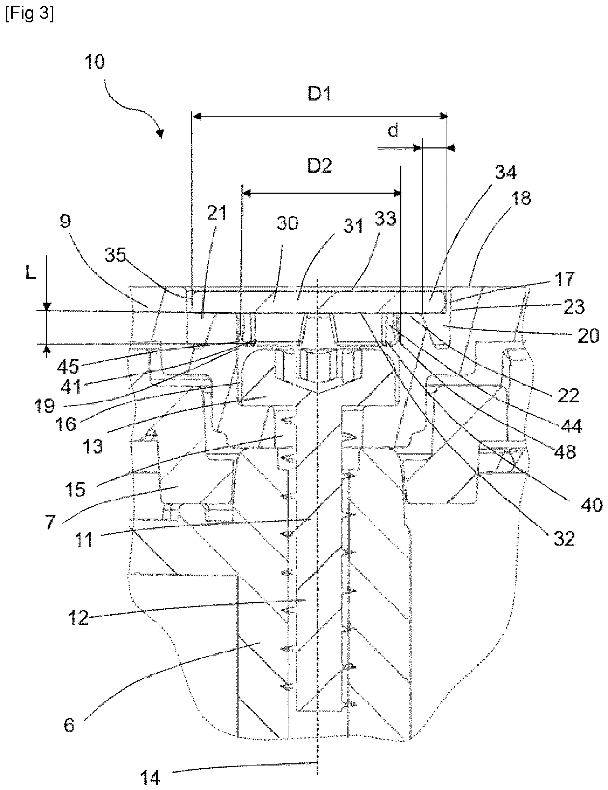

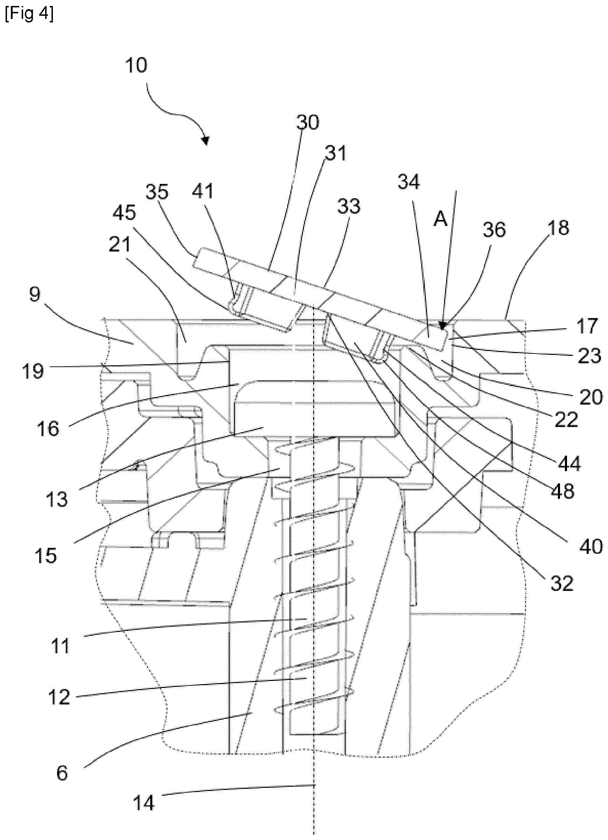

La machine à café comporte un dispositif de fixation 10 par vissage du panneau 9 sur le bâti 6. Le dispositif de fixation 10 comporte donc une vis 11 munie d'un fût 12 et d'une tête 13. Le fût 12 et la tête 13 de la vis 11 s'étendent selon un axe longitudinal 14. Le panneau 9 comporte un trou de passage 15 du fût 12 de la vis 11 et un trou de réception 16 de la tête 13 de la vis 11. Le dispositif de fixation 10 comporte un cache vis 30 destiné à masquer la tête 13 de la vis 11. Le panneau 9 comporte un logement de réception 17 du cache vis 30 agencé dans le prolongement du trou de réception 16 de la tête 13 de la vis 11, au-dessus de la tête 13. Le cache vis 30 est mobile entre une position fermée (Fig. 3) dans laquelle le cache vis 30 est positionné dans le logement de réception 17 pour fermer le trou de réception 16 de la tête 13 de la vis 11 et une position ouverte (Fig. 2) dans laquelle le cache vis 30 est séparé du panneau 9 pour libérer l'accès au trou de réception 16 de la tête 13 de la vis 11. Tel que visible aux figures 3 et 4, la vis 11 est vissée dans le bâti 6 pour amener le panneau 9 en appui sur le bâti 6. Le panneau 7 d'habillage droit est immobilisé entre le bâti 6 est le panneau 9 lors de l'assemblage par vissage.

Conformément à la figure 2, le logement de réception 17 et le cache vis 30 sont de forme circulaires. Le cache vis 30 comporte un corps 31 en forme de disque et qui présente une épaisseur sensiblement constante. Le corps 31 comporte une face interne 32 orientée vers le trou de réception 16 de la tête 13 de la vis 11 et une face externe 33 orientée vers l'extérieur de la machine à café. La face externe 33 du corps 31 est sensiblement dans le même plan qu'une face externe 18 du panneau 9. Le corps 31 du cache vis 30 comporte un bord périphérique 34 et le logement de réception 17 comporte une rainure périphérique 20. La rainure périphérique 20 comporte une ouverture annulaire 21. Tel que visible à la figure 3, dans la position fermée, le bord périphérique 34 du corps 31 recouvre la rainure périphérique 20, notamment l'ouverture annulaire 21. Le trou de réception 16 de la tête 13 de la vis 11 comporte une extrémité libre 19. L'extrémité libre 19 comporte une collerette 22 qui est entourée par la rainure périphérique 20. Dans la position fermée, le bord périphérique 34 du corps 31 est en appui sur la collerette 22. Le logement de réception 17 du cache vis 30 comporte une paroi externe 23 périphérique et le bord périphérique 34 du cache vis 30 comporte une face externe périphérique 35. La face externe périphérique 35 est positionnée au voisinage de la paroi externe 23 périphérique lorsque le cache vis 30 est dans la position fermée pour limiter le jeu du cache vis 30 dans son logement de réception 17.

Tel que visible à la figure 4, un appui A sur une zone 36 du bord périphérique 34 fait pénétrer la zone 36 dans la rainure périphérique 20 pour faire basculer le cache vis 30 dans une position inclinée de saisie dans laquelle le cache vis 30 peut être pris et déplacé dans la position ouverte. Par appui A sur une zone 36 du bord périphérique 34, on comprend un appui A sur la face externe 33, à proximité de la face externe périphérique 35, l'appui A étant réalisé à l'aplomb de la rainure périphérique 20, à proximité de la face externe périphérique 35. L'appui A est visualisé par une flèche A sur la figure 4.

Conformément à la figure 3, le corps 31 du cache vis 30 présente un diamètre extérieur D1 égal à 11,6 millimètres et le bord périphérique 34 s'étend au-dessus de la rainure périphérique 20 sur une distance d égale à 1,16 millimètres. La distance d représente 10% du diamètre D1.

Conformément aux figures 2, 3 et 4, le cache vis 30 comporte un organe de maintien 40 qui coopère avec le trou de réception 16 de la tête 13 de la vis 11 lorsque le cache vis 30 est dans la position fermée. L'organe de maintien 40 est formé par quatre pattes 41, 42, 43, 44 (Fig. 2) qui sont agencées sur la face interne 32 du corps 31. Les quatre pattes 41, 42, 43, 44 sont positionnées sur un cercle et sont réparties uniformément tous les 90°. Les quatre pattes 41, 42, 43, 44 s'étendent le long de l'axe longitudinal 14. Les quatre pattes 41, 42, 43, 44 sont légèrement flexibles et comportent chacune un bourrelet 45, 46, 47, 48 (Fig. 2) d'extrémité destiné à coopérer avec le trou de réception 16 de la tête 13 de la vis 11. Dans la position fermée, les quatre pattes 41, 42, 43, 44 sont légèrement fléchies pour être agencées de manière serrante dans une extrémité libre 19 du trou de réception 16 de la tête 13 de la vis 11. Tel que visible à la figure 3, dans la position fermée, les pattes 41, 42, 43, 44 s'étendent le long de l'axe longitudinal 14 d'extension de la vis 11 sur une longueur L égale à 1,5 millimètres. Le trou de réception de la tête de vis présente un diamètre D2 égal à 7,4 millimètres. La longueur L représente 19% du diamètre D2.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention telle que déterminée par les revendications.

Ainsi, dans une variante de réalisation non illustrée, la rainure périphérique 20 est localisée sur une partie de la périphérie du logement de réception 17. Le dispositif de fixation comporte un moyen visuel pour indiquer à l'utilisateur où réaliser l'appui A.

## Revendications

1. Appareil domestique (1), notamment une machine à café, comportant un bâti (6), un panneau (9) et un dispositif de fixation (10) par vissage du panneau (9) sur le bâti (6), ledit dispositif de fixation (10) comportant une vis (11) munie d'une tête (13) ainsi qu'un cache vis (30), ledit panneau (9) comportant un trou de passage (15) de la vis (11), un trou de réception (16) de la tête (13) de la vis (11) et un logement de réception (17) du cache vis (30) agencé dans le prolongement du trou de réception (16) de la tête (13) de la vis (11), ledit cache vis (30) étant mobile entre une position fermée dans laquelle le cache vis (30) est positionné dans le logement de réception (17) pour fermer le trou de réception (16) de la tête (13) de la vis (11) et une position ouverte dans laquelle le cache vis (30) est séparé du panneau (9) pour libérer l'accès au trou de réception (16) de la tête (13) de la vis (11), le cache vis (30) comportant un bord périphérique (34) et le logement de réception (17) comportant une rainure périphérique (20) recouverte par le bord périphérique (34) lorsque le cache vis (30) est dans la position fermée, **caractérisé en ce qu'** un appui A sur une zone (36) du bord périphérique (34) faisant pénétrer ladite zone (36) dans la rainure périphérique (20) pour faire basculer le cache vis (30) dans une position inclinée de saisie dans laquelle le cache vis (30) peut être pris et déplacé dans la position ouverte.

2. Appareil domestique (1)selon la revendication 1, **caractérisé en ce que** le trou de réception (16) de la tête (13) de la vis (11) comporte une extrémité libre (19) et **en ce que** l'extrémité libre (19) comporte une collerette (22) qui est entourée par la rainure périphérique (20).

3. Appareil domestique (1) selon l'une quelconque des revendications 1 à 2, **caractérisé en ce que** le logement de réception (17) comporte une paroi externe (23) périphérique et **en ce que** le bord périphérique (34) du cache vis (30) comporte une face externe périphérique (35), la face externe périphérique (35) étant positionnée à proximité de la paroi externe (23) périphérique lorsque le cache vis (30) est dans la position fermée.

4. Appareil domestique (1) selon l'une quelconque des revendications 1 à 3, **caractérisé en ce que** le logement de réception (17) et le cache vis (30) sont circulaires.

5. Appareil domestique (1) selon la revendication 4, **caractérisé en ce que** le cache vis (30) présente un diamètre extérieur D1 et **en ce que** le bord périphérique (34) s'étend au-dessus de la rainure périphérique (20) sur une distance d, la distance d étant supérieure ou égale à D1/10.

6. Appareil domestique (1) selon l'une quelconque des revendications 1 à 5, **caractérisé en ce que** le cache vis (30) comporte un organe de maintien (40) agencé dans le trou de réception (16) de la tête (13) de la vis (11) lorsque le cache vis (30) est dans la position fermée.

7. Appareil domestique (1) selon la revendication 6, **caractérisé en ce que** l'organe de maintien (40) est formé par des pattes (41, 42, 43, 44) qui sont agencées de manière serrante dans une extrémité libre (19) du trou de réception (16) de la tête (13) de la vis (11) lorsque le cache vis (30) est dans la position fermée.

8. Appareil domestique (1) selon la revendication 7, **caractérisé en ce que**, dans la position fermée, les pattes (41, 42, 43, 44) s'étendent le long d'un axe longitudinal d'extension de la vis sur une longueur L et **en ce que** le trou de réception de la tête de vis présente un diamètre D2 , la longueur L étant inférieure à D2/4.

9. Appareil domestique (1) selon l'une quelconque des revendications 7 à 8, **caractérisé en ce que** chaque patte (41, 42, 43, 44) comporte un bourrelet (45, 46, 47, 48) d'extrémité.

## Patentansprüche

1. Haushaltsgerät (1), insbesondere eine Kaffeemaschine, wobei das Gerät ein Gehäuse (6), eine Platte (9) und eine Befestigungsvorrichtung (10) zum Anschrauben der Platte (9) am Gehäuse (6) umfasst, wobei die Befestigungsvorrichtung (10) eine Schraube (11) mit einem Kopf (13) und eine Schraubenabdeckung (30) umfasst, wobei die Platte (9) ein Durchgangsloch (15) für die Schraube (11), ein Aufnahmeloch (16) für den Kopf (13) der Schraube (11) und ein Aufnahmeraum (17) für die Schraubenabdeckung (30) im Anschluss an das Aufnahmeloch (16) für den Kopf (13) der Schraube (11) umfasst, wobei die Schraubenabdeckung (30) zwischen einer geschlossenen Position, in der die Schraubenabdeckung (30) im Aufnahmeraum (17) positioniert ist, um das Aufnahmeloch (16) für den Kopf (13) der Schraube (11) zu schließen, und einer offenen Position, in der die Schraubenabdeckung (30) von der Platte (9) getrennt ist, um Zugang zum Aufnahmeloch (16) für den Kopf (13) der Schraube (11) zu gewähren, beweglich ist, wobei die Schraubenabdeckung (30) einen Rand (34) und der Aufnahmeraum (17) einen umlaufenden Rillenbereich (20) umfasst, der vom Rand (34) abgedeckt wird, wenn die Schraubenabdeckung (30) in der geschlossenen Position ist, **dadurch gekennzeichnet, dass** ein Druck auf einen Bereich (36) des Randes (34) dafür sorgt, dass der Bereich (36) in den umlaufenden Rillenbereich (20) eindringt und die Schraubenabdeckung (30) in eine kippbare Greifposition versetzt wird, in der die Schraubenabdeckung (30) gegriffen und in die offene Position bewegt werden kann.

2. Haushaltsgerät (1) gemäß Anspruch 1, **dadurch gekennzeichnet, dass** das Aufnahmeloch (16) für den Kopf (13) der Schraube (11) ein offenes Ende (19) umfasst und das offene Ende (19) einen Flansch (22) umfasst, der vom umlaufenden Rillenbereich (20) umgeben ist.

3. Haushaltsgerät (1) gemäß einem der Ansprüche 1 bis 2, **dadurch gekennzeichnet, dass** der Aufnahmeraum (17) eine äußere Wand (23) umfasst und der Rand (34) der Schraubenabdeckung (30) eine äußere Randfläche (35) umfasst, wobei die äußere Randfläche (35) nahe der äußeren Wand (23) positioniert ist, wenn die Schraubenabdeckung (30) in der geschlossenen Position ist.

4. Haushaltsgerät (1) gemäß einem der Ansprüche 1 bis 3, **dadurch gekennzeichnet, dass** der Aufnahmeraum (17) und die Schraubenabdeckung (30) kreisförmig sind.

5. Haushaltsgerät (1) gemäß Anspruch 4, **dadurch gekennzeichnet, dass** die Schraubenabdeckung (30) einen Außendurchmesser D1 hat und der Rand (34) sich über dem Rillenbereich (20) um eine Distanz d erstreckt, wobei die Distanz d größer oder gleich D1/10 ist.

6. Haushaltsgerät (1) gemäß einem der Ansprüche 1 bis 5, **dadurch gekennzeichnet, dass** die Schraubenabdeckung (30) ein Halteelement (40) umfasst, das im Aufnahmeloch (16) für den Kopf (13) der Schraube (11) angeordnet ist, wenn die Schraubenabdeckung (30) in der geschlossenen Position ist.

7. Haushaltsgerät (1) gemäß Anspruch 6, **dadurch gekennzeichnet, dass** das Halteelement (40) aus Laschen (41, 42, 43, 44) besteht, die im offenen Ende (19) des Aufnahmelochs (16) für den Kopf (13) der Schraube (11) so angeordnet sind, dass sie dort einen festen Halt bieten, wenn die Schraubenabdeckung (30) in der geschlossenen Position ist.

8. Haushaltsgerät (1) gemäß Anspruch 7, **dadurch gekennzeichnet, dass** die Laschen (41, 42, 43, 44) in der geschlossenen Position entlang einer Längsachse der Schraube über eine Länge L verlaufen und dass das Aufnahmeloch für den Schraubenkopf einen Durchmesser D2 hat, wobei die Länge L kürzer ist als D2/4.

9. Haushaltsgerät (1) gemäß einem der Ansprüche 7 bis 8, **dadurch gekennzeichnet, dass** jede Lasche (41, 42, 43, 44) eine Endwulst (45, 46, 47, 48) umfasst.

## Claims

1. Domestic appliance (1), particularly a coffee machine, comprising a housing (6), a panel (9) and a fastening device (10) for screwing the panel (9) onto the housing (6), said fastening device (10) comprising a screw (11) with a head (13) and a screw cover (30), the panel (9) comprising a passage hole (15) for the screw (11), a reception hole (16) for the head (13) of the screw (11) and a reception housing (17) for the screw cover (30) arranged in continuation of the reception hole (16) for the head (13) of the screw (11), the screw cover (30) being movable between a closed position in which the screw cover (30) is positioned in the reception housing (17) to close the reception hole (16) for the head (13) of the screw (11) and an open position in which the screw cover (30) is separated from the panel (9) to allow access to the reception hole (16) for the head (13) of the screw (11), the screw cover (30) comprising a peripheral edge (34) and the reception housing (17) comprising a peripheral groove (20) covered by the peripheral edge (34) when the screw cover (30) is in the closed position, **characterized in that** applying pressure on an area (36) of the peripheral edge (34) causes said area (36) to penetrate into the peripheral groove (20), hinging the screw cover (30) into a graspable inclined position allowing the screw cover (30) to be taken and moved to the open position.

2. Domestic appliance (1) according to claim 1, **characterized in that** the reception hole (16) for the head (13) of the screw (11) comprises a free end (19) and **in that** the free end (19) comprises a flange (22) which is surrounded by the peripheral groove (20).

3. Domestic appliance (1) according to any one of claims 1 to 2, **characterized in that** the reception housing (17) comprises an external peripheral wall (23) and **in that** the peripheral edge (34) of the screw cover (30) comprises an external peripheral face (35), the external peripheral face (35) being positioned close to the external peripheral wall (23) when the screw cover (30) is in the closed position.

4. Domestic appliance (1) according to any one of claims 1 to 3, **characterized in that** the reception housing (17) and the screw cover (30) are circular.

5. Domestic appliance (1) according to claim 4, **characterized in that** the screw cover (30) has an outer diameter D1 and **in that** the peripheral edge (34) extends over the peripheral groove (20) by a distance d, where the distance d is greater than or equal to D1/10.

6. Domestic appliance (1) according to any one of claims 1 to 5, **characterized in that** the screw cover (30) comprises a retaining member (40) arranged in the reception hole (16) for the head (13) of the screw (11) when the screw cover (30) is in the closed position.

7. Domestic appliance (1) according to claim 6, **characterized in that** the retaining member (40) is formed by flanges (41, 42, 43, 44) which are arranged to grip in a free end (19) of the reception hole (16) for the head (13) of the screw (11) when the screw cover (30) is in the closed position.

8. Domestic appliance (1) according to claim 7, **characterized in that**, in the closed position, the flanges (41, 42, 43, 44) extend along a longitudinal axis of extension of the screw over a length L and **in that** the reception hole for the screw head has a diameter D2, with the length L being less than D2/4.

9. Domestic appliance (1) according to any one of claims 7 to 8, **characterized in that** each flange (41, 42, 43, 44) comprises an end bulge (45, 46, 47, 48).
